# EUROPEAN PATENT APPLICATION

(11) **EP 0 766 318 A1**
(43) Date of publication of application: **02.04.1997**
(21) Application number: 96909342.6
(22) Date of filing: 11.04.1996
(51) Int. Cl.: H01L 29/78

(54) **SEMICONDUCTOR DEVICE HAVING PLANAR TYPE HIGH WITHSTAND VOLTAGE VERTICAL DEVICES, AND PRODUCTION METHOD THEREOF**

(30) Priority: 11.04.1995 JP 85203/95
(71) Applicant: ROHM CO., LTD., Kyoto-shi Kyoto 615 (JP)
(72) Inventor: SAKAMOTO, Kazuhisa Rohm Co., Ltd., Kyoto 615 (JP)
(74) Representative: Beresford, Keith Denis Lewis
(86) International application number: JP9600997
(87) International publication number: WO9632749

(57) **Abstract**

An object of the present invention is to provide an IBGT which satisfied with a reliable high breakdown-voltage proof characteristic and occupies smaller device formation region with lower power consumption. An n-- type semiconductor layer 38 is formed on a part where has tendency to cause break down, and an n - type semiconductor substrate 36 is formed underneath the n-- type semiconductor layer 38. As a result, the value of theoretical breakdown-voltage of the n-- type semiconductor layer 38 become greater than that of the n - type semiconductor substrate 36. Also, the n - type semiconductor substrate 36 having lower electric resistance is located underneath the n-- type semiconductor layer 38. Therefore, lower power consumption is expected because electric resistance of the part where determines a power consumption of the IGBT is decreased.

## Description

### [Field of the Invention]

The present invention relates to a semiconductor device having a planar type vertical element with high breakdown-voltage proof structure and a method thereof, more specifically, a structure of a semiconductor substrate which is enable to realize a semiconductor device having high breakdown-voltage proof characteristic and lower power consumption.

### [Background of the prior art]

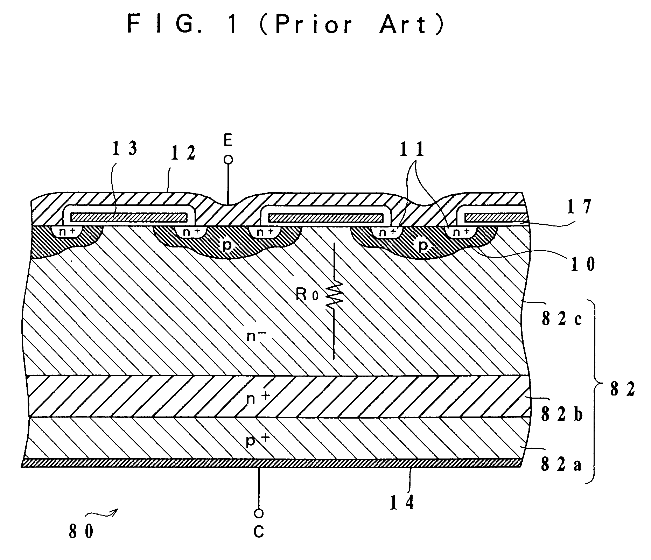

In the past, an insulated gate bipolar transistor having high breakdown-voltage proof structure shown in Fig. 1 (hereinafter referred to as IGBT 80) is known as a semiconductor device having a planar type vertical element with high breakdown-voltage proof structure. The IGBT 80 is a semiconductor device which comprises both the characteristic of high-input impedance observed on a metal oxide silicon field effect transistors (herein after referred to as a MOSFET) and that of the low-saturation voltage generated by the bipolar transistor.

A semiconductor substrate 82 of the IGBT 80 comprises a p+ type conductive layer 82a, an n+ type layer 82b and an n- type layer 82c. A p type region 10 is formed in the n- type layer 82c, and an n+ type region 11 is formed in the p type region 10. A surface of the n- type layer 82c is covered with a gate oxidation layer 17.

The IGBT 80 is turned into on-state with supply of a base current of a PNP transistor generated by on-state of the MOSFET when a positive bias voltage is applied between a gate and an emitter of the IGBT 80.

In the IGBT 80, occurrence of break down is observed adjacent to the surface of the semiconductor substrate even when the value of the applied voltage is not greater than that of a theoretical breakdown-voltage. This is because thickness of a depletion region on the surface of semiconductor substrate is thinner than that of a bulk due to existence of impurities in the boundary between the surface and an insulating layer such as an oxidation layer or the like.

In order to prevent occurrence of break down, it is considered to decrease density of the impurities of the n- type layer 82c for increasing the value of theoretical breakdown-voltage for the number of decrease. To do that, more power consumption is expected because of increment of electric resistance R0 of the n- type layer 82c. So that, in the conventional IGBT 80, either of a field limiting ring (hereinafter referred to as FLR, not shown) or a field plate (hereinafter referred to as FP, not shown) is utilized to satisfy with both a reliable high breakdown-voltage proof characteristic and lower power consumption.

### [Disclosure of the present invention]

However, the IGBT 80 has a following problem to be resolved. By utilizing the FLR or the FP as described in the above, the semiconductor device is made larger than originally expected because area of device formation regions is increased.

The problem may be caused on not only the IGBT, but also all the semiconductor devices having a planar type vertical element with high breakdown-voltage proof structure.

It is an object of the present invention to provide a semiconductor device having a planar type vertical element with high breakdown-voltage proof structure which satisfy with both a reliable high breakdown-voltage proof characteristic and lower power consumption and occupies smaller device formation regions and a method thereof, as well as resolving the problem stated in the above.

In accordance with characteristic of the present invention, a semiconductor device having a planar type vertical element with high breakdown-voltage proof structure comprises:
an impurity layer of first conductive type,
a very low impurity layer of first conductive type located on the impurity layer of first conductive type, the very low density impurity layer of first conductive type having lower impurity density than the impurity layer of first conductive type, and
an impurity region of second conductive type located in the very low density impurity layer of first conductive type.

Also, in accordance with characteristic of the present invention, a semiconductor device having a planar type vertical element with high breakdown-voltage proof structure,
wherein the impurity layer of first conductive type comprises a high density impurity layer of first conductive type and a low density impurity layer of first conductive type located on the high density impurity layer of first conductive type.

Further, in accordance with characteristic of the present invention, a semiconductor device having a planar type vertical element with high breakdown-voltage proof structure further comprises:
a high density impurity layer of second conductive type located under the high density impurity layer of first conductive type,
an impurity region of first conductive type located in the impurity region of second conductive type,
a gate oxidation film covering the impurity region of second conductive type, and
a gate electrode located on the gate oxidation film, the gate electrode generating a first conductive type channel on a surface of the high density impurity layer of second conductive type when a voltage greater than a threshold voltage being applied thereto, so that the impurity region of first conductive type and the very low density impurity layer of first conductive type being connected electrically with each other.

Still further, in accordance with characteristic of the present invention, a semiconductor device having a planar type vertical element with high breakdown-voltage proof structure,
wherein bottom surface of the impurity region of second conductive type reaches to the low density impurity layer of first conductive type.

In accordance with characteristic of the present invention, a method for manufacturing a semiconductor device having a planar type vertical element with high breakdown-voltage proof structure comprises:
forming a high density impurity layer of first conductive type by carrying out thermal diffusion of first conductive type impurities on a surface of a semiconductor substrate being implanted the first conductive type impurities at a low density,
forming a low density impurity layer of first conductive type having lower impurity density than the semiconductor substrate by utilizing epitaxial growth method on a surface of the semiconductor substrate where the high density impurity layer of first conductive type is not formed, and
forming an impurity region of second conductive type in the very low density impurity layer of first conductive type.

Also, in accordance with characteristic of the present invention, a method for manufacturing a semiconductor device having a planar type vertical element with high breakdown-voltage proof structure, the improvement comprises:
forming a high density impurity layer of second conductive type by carrying out thermal diffusion of second conductive type impurities on a surface of the high density impurity layer of first conductive type, the surface not being adjacent to the semiconductor substrate,
forming an impurity region of first conductive type in the impurity region of second conductive type,
forming a gate oxidation film covering a surface of the impurity region of second conductive type,
forming a gate electrode on the gate oxidation film, the gate electrode generating a first conductive type channel on a surface of the high density impurity layer of second conductive type when a voltage greater than a threshold voltage being applied thereto, so that the impurity region of first conductive type and the very low density impurity layer of first conductive type being connected electrically with each other.

While the novel features of the invention are set forth in a general fashion, both as to organization and content, it will be better understood and appreciated, along with other objections and features thereof, from the following detailed description taken in conjunction with the drawings.

### [BRIEF DESCRIPTION OF THE DRAWINGS]

Fig. 1 is a sectional view of the main part of an IGBT 80 in the prior art.

Fig. 2 is a sectional view of the main part of an IGBT 1 as an embodiment of the present invention.

Fig. 3A, Fig. 3B and Fig. Fig. 3C are process flows showing manufacturing processes of the IGBT 1 in the present invention.

Fig. 4A and Fig. 4B are process flows showing manufacturing processes of the IGBT 1 in the present invention.

Fig. 5 is a graph showing a relationship between depth from the surface of the semiconductor layer and density of impurities in the IGBT 1.

Fig. 6 is a sectional view of the main part of a power MOSFET which applies the present invention.

### [THE BEST MODE OF THE PRESENT INVENTION]

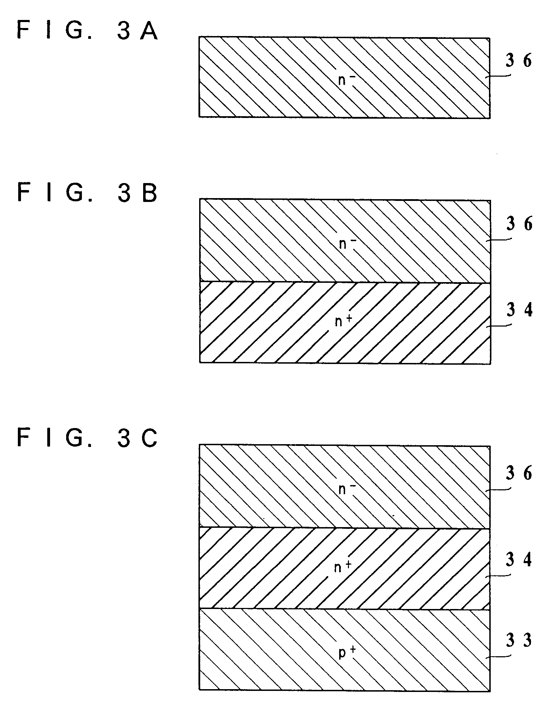

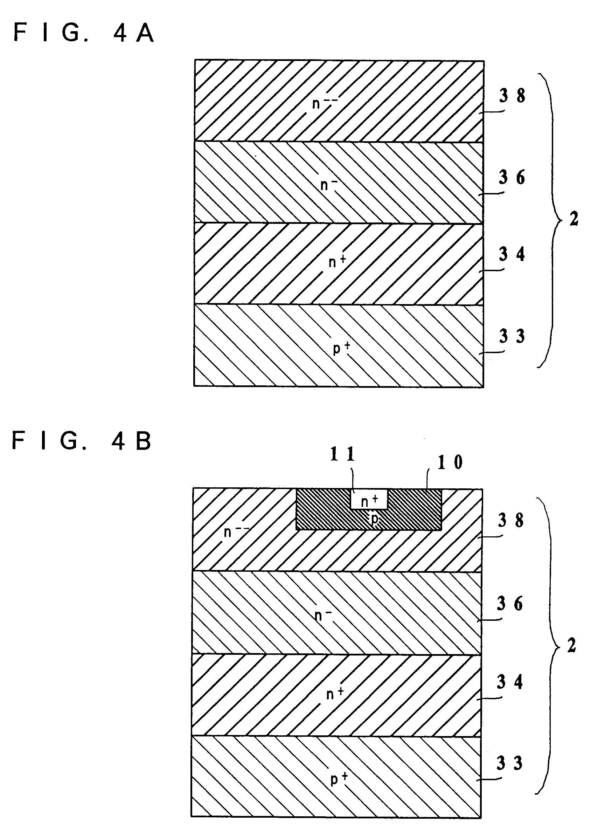

An embodiment of the present invention will be described with reference to the figures. Fig. 3A, Fig. 3B, Fig. 3C Fig. 4A and Fig. 4B are views showing manufacturing processes of an IGBT 1 as the embodiment of the present invention.

As shown in Fig. 3A, an n- type semiconductor substrate 36 having an impurity density of approximately from 3 X 10¹³/cm³ to 5 X 10¹⁴/cm³ is prepared. Thereafter, an n+ type semiconductor layer 34 having an impurity density of approximately from 1 X 10¹⁴/cm³ to 1 X 10 ¹⁷/cm³ is formed by carrying out diffusion of p type impurities such as arsenic, phosphor and antimony and the like to a surface of the n- type semiconductor substrate 36. Thickness of the n+ type semiconductor layer 34 is preferably between a range of 10µm to 50µm, and more preferably in approximately 20µm.

Then, a p+ type semiconductor layer 33 having an impurity density of approximately from 1 X 10¹⁹/cm³ is formed by carrying out diffusion of p type impurities such as phosphor and the like on the n+ type semiconductor layer 34 as shown in Fig. 3C. Thickness of the p+ type semiconductor layer 33 can be formed approximately in a range between 10µm to 50µm, the thickness can be adjusted freely unless otherwise too thin.

An n-- type semiconductor layer 38 is formed by a method of epitaxial growth on the other surface of the n- type semiconductor substrate 36 where the n+ type semiconductor layer 34 is not formed as shown in Fig. 4A. The impurity density of the n-- type semiconductor layer 38 is approximately 3 X 10¹³/cm³, so that the impurity density is less than that of the n- type semiconductor substrate 36. Thickness of the n-- type semiconductor layer 38 is preferably between a range of 10µm to 50µm, and more preferably in approximately 20µm. This is because thicker semiconductor layer 38 makes higher electric resistance, and thinner semiconductor layer 38 invites degradation of high breakdown-voltage proof characteristic.

Thus, a semiconductor substrate 2 comprising the p+ type semiconductor layer 33, the n+ type semiconductor layer 34, the n- type semiconductor substrate 36 and the n-- type semiconductor layer 38 is formed. Each of a high density impurity layer of second conductive type, a high density impurity layer of first conductive type, a low density impurity layer of first conductive type and a very low density impurity layer of first conductive type are composed of the p+ type semiconductor layer 33, the n+ type semiconductor layer 34, the n- type semiconductor substrate 36 and the n-- type semiconductor layer 38 respectively in this embodiment.

Next, a p type region 10 is formed in the n-- type semiconductor layer 38 of the semiconductor substrate 2 by utilizing either of ion implantation method or diffusion method. An n+ type region 11 is formed in the same manner as the p type region 10. The p type region 10 and the n+ type region 11 composes the impurity region of second conductive type and the impurity region of first conductive type respectively in this embodiment.

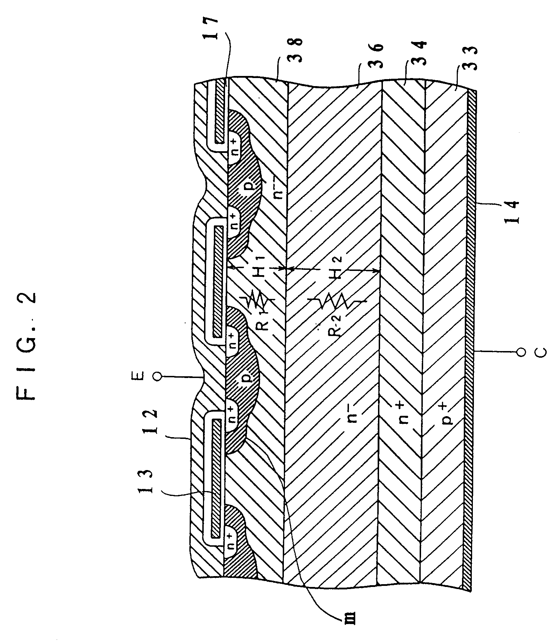

Thereafter, a gate electrode 13 and an emitter electrode 14 and a collector electrode 14 are formed on the a silicon oxidation film 17 formed on the surface of the n-- type semiconductor layer 38. Thus, the IGBT 1 shown in Fig. 2 is completed.

Since, the manufacturing processes described in the above do not require an epitaxial growth process of the base regions of the IGBT which need to be done in the conventional method, so that the method in the present invention offers cut down of the time for manufacturing and 40% reduction of the manufacturing cost.

The IGBT 1 shown in Fig. 2 is formed on the semiconductor substrate 2. In the semiconductor substrate 2, the n+ type semiconductor layer 34, the n- type semiconductor substrate 36 and the n-- type semiconductor layer 38 are formed in order of that on the p+ type semiconductor layer 33. The p type region 10 is formed into the n-- type semiconductor layer 38. The n+ type region 11 is formed in the p type region 10. A surface of the n-- type semiconductor layer 38 is covered with the gate oxidation film 17. Both the gate electrode 13 and the emitter electrode 12 are provided on the gate oxidation film 17.

A channel region 16 as the first conductive type channel is on-state when a voltage greater than the threshold voltage is applied to the gate electrode 13, so that a current flows from the collector electrode 14 to the emitter electrode 12.

In this embodiment, all the first conductive type impurities are considered as n type and all the second conductive type impurities are defined as p type. Impurity density and thickness of the semiconductor layers in the semiconductor substrate 2 of the IGBT 1 are shown as follows.
1) n-- type semiconductor layer 38
   impurity density : approximately 3 X 10¹³/cm³
   thickness : approximately 20µm from the surface of the substrate
2) n- type semiconductor substrate 36
   impurity density : approximately from 3 X 10¹³/cm³ to 5 X 10¹⁴/cm³
   thickness : approximately 120µm from the surface of the substrate
3) n+ type semiconductor layer 34
   impurity density : approximately from 1 X 10¹⁴/cm³ to 1 X 10¹⁷/cm³
   thickness : approximately 20µm
4) p+ type semiconductor layer 33
   impurity density : approximately 1 X 10¹⁹/cm³
   thickness : approximately 250µm from the surface of the substrate

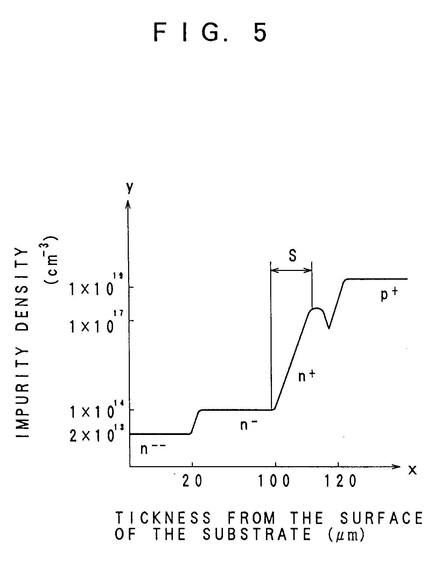

Fig. 5 is a graph showing a relationship between thickness of the semiconductor layers and impurity density. The axis of abscissas X and the axis of ordinates Y correspond to a thickness from the surface of the substrate to the semiconductor layers and impurity density respectively.

Thus, the n-- type semiconductor layer 38 in which formed a pn junction m having high breakdown-voltage proof structure (see Fig. 2) has less impurity density than the n- type semiconductor substrate 36 in the IGBT 1. The value of theoretical breakdown-voltage is in inversely proportional to the impurity density. So that, the value of theoretical breakdown-voltage of the n-- type semiconductor layer 38 becomes greater than that of the n- type semiconductor substrate 36. A surface breakdown voltage can be increased for the amount of the increased voltage. As a result, the surface breakdown voltage can be increased without using the FLR and the like.

On the other hand, as shown in Fig. 2, the n- type semiconductor substrate 36 is formed underneath the n-- type semiconductor layer 38 being formed adjacently to the surface in order to increase a value of the surface breakdown voltage to a high level. Since electric resistance of the n- type semiconductor substrate 36 is less than that of the n-- type semiconductor layer 38, lower power consumption can be expected in comparison with when the n- type semiconductor substrate 36 is not provided underneath the n-- type semiconductor layer 38.
Especially, the power consumption is determined by the sum of electric resistance R1 of the n-- type semiconductor layer 38 and electric resistance R2 of the n- type semiconductor substrate 36 in the IGBT 1. Although, resistivity of the n-- type semiconductor layer 38 is approximately twice to ten times as much of that of the n- type semiconductor substrate 36 due to difference of the impurity density between them, thickness H1 of the n-- type semiconductor layer 38 is remarkably thinner than thickness H2 of the n- type semiconductor substrate 36. So that, the value of the electric resistance R2 occupies most of the sum of electric resistance R1 + R2.

It is possible to make the electric resistance R1 to the minimum value by carrying out diffusion to the n- type semiconductor substrate 36 with making the thickness of diffusion of the p type region 10 thicker. Thus, an IGBT which consumes lower electric power can be realized.

In this case, the thickness of diffusion of the p type region 10 can be made thinner by making the thickness of the n-- type semiconductor layer 38 thinner. In general, thicker p type region 10 suffers higher breakdown-voltages. However, since the high breakdown-voltage proof characteristic is kept under high level by carrying out diffusion of the p type region 10 in the n-- type semiconductor layer 38 with forming the n-- type semiconductor layer 38 on the surface of the substrate, so that a sufficient high breakdown-voltage proof characteristic can be maintained even when the p type region 10 is made thinner. As a result of that, the time for manufacturing the semiconductor device can be reduced because duration of diffusion for forming the p type region 10 can be shorten.

Thus, by forming the n-- type semiconductor layer 38 on the surface of the semiconductor substrate, an IGBT satisfied with a reliable high breakdown-voltage proof characteristic and occupies smaller device formation region without much increase of power consumption can be obtained.

In the manufacturing processes shown from in Fig. 3A to Fig. 4B, both the p+ type semiconductor layer 33 and the n+ type semiconductor layer 34 are formed on a surface of the n- type semiconductor substrate 36 by carrying out thermal diffusion, further to that the n-- type semiconductor layer 38 having lower impurity density than the semiconductor substrate is formed by utilizing epitaxial growth method on a surface of the semiconductor substrate where the high density impurity layer of first conductive type is not formed. In other words, the semiconductor substrate 2 is formed by accumulating a total of three semiconductor layers on the prepared semiconductor substrate using epitaxial growth method at once and using thermal diffusion method at twice. So that, some of the manufacturing processes can be omitted in comparison with the case when all of three layers are formed by using epitaxial growth method.

Also, the n-- type semiconductor layer 38 is formed on the other surface of the n- type semiconductor substrate 36 where the n+ type semiconductor layer 34 is not formed. That is, the IGBT does not receive much influences of crystal defects caused by the thermal history applied thereto because the n-- type semiconductor layer 38 is not formed on a semiconductor layer made by thermal diffusion.

Further, a gentle boundary of impurity density between the n- type semiconductor substrate 36 and the n+ type semiconductor layer 34 is observed (see S of Fig. 5) in the semiconductor substrate using thermal diffusion method as described in above. So that, the IGBT made under this manufacturing method can be operated under short pulses, and it offers a wide range of proper operation. The semiconductor substrate 2 of the IGBT 1 can also be manufactured in the usual manners. That is, the semiconductor substrate 2 can be manufactured by forming an n+ type semiconductor layer, an n- type semiconductor layer and an n-- type semiconductor layer in that order on a p+ type semiconductor substrate using epitaxial growth method. In this case, a steep boundary of impurity density between the n- type semiconductor layer and the n+ type semiconductor layer is observed.

Although the IGBT is employed as a semiconductor device having a planar type vertical element with high breakdown-voltage proof structure in this embodiment, it is possible to apply the present invention to a semiconductor device having an IGBT.

In the meantime, the present invention can be applied to any types of semiconductor devices having a planar type vertical element with high breakdown-voltage proof structure for instance a power MOSFET, a diode and a thyristor and the like.

Since the embodiment stated in the above describes when the present invention is applied to the IGBT, so that the n+ type semiconductor layer 34 that serve as the high impurity density layer of first conductive type is formed on the surface of the n- type semiconductor substrate 36, and the p+ type semiconductor layer 33 that serve as the high impurity density layer of second conductive type is formed underneath the n+ type semiconductor layer 34. Also, the n+ type region 11 is formed in the p type region 10, the gate oxidation film 17 and the gate electrode 13 are formed therein. The present invention can be applied to a semiconductor device having a planar type vertical element with high breakdown-voltage proof structure which does not comprises the p+ type semiconductor layer 33, the n+ type region 11, the gate oxidation film 17 and the gate electrode 13 unless the semiconductor device at least has a planar type vertical element with high breakdown-voltage proof structure except for the IGBT. The present invention can also be applied to a semiconductor device having a planar type vertical element with high breakdown-voltage proof structure in which the high density impurity layer of first conductive type is made of the impurity layer of first conductive type.

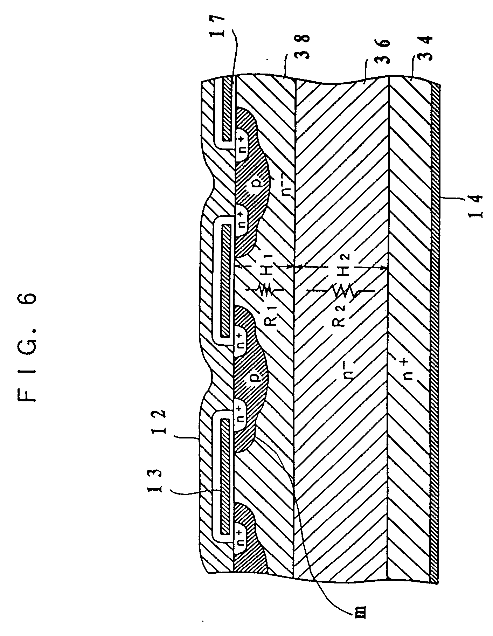

Fig. 6 shows a semiconductor device having a planar type vertical element with high breakdown-voltage proof structure comprises a power MOSFET which employs the present invention.

The power MOSFET shown in Fig. 6 is a vertical type FET using a semiconductor substrate 42 as a drain, and the semiconductor substrate 42 comprises an n+ type semiconductor layer 42a, an n- type semiconductor layer 42b and an n-- type semiconductor layer 42c. A source 48, a source electrode 46, a gate polysilicon layer (PolySi) 47 and a gate insulating layer (SiO₂) 43 are formed on the semiconductor substrate 42.

In other words, each of the high density impurity layer of high conductive type, the low density impurity layer of first conductive type, the very low density impurity layer of first conductive type and the impurity region of second conductive type are composed of the n+ type semiconductor layer 42a, the n- type semiconductor layer 42b, the n-- type semiconductor layer 42c and a p type region 10 respectively in this embodiment.

In the power MOSFET, a current flows from the drain 42 to the source 48 as a result of forming a channel on a channel region 44 when a voltage greater than the threshold voltage is applied to the gate polysilicon layer 47.

Also, a power MOSFET satisfied with a reliable high breakdown-voltage proof characteristic and occupies smaller device formation region without much increase of power consumption can be realized.

Further to the power MOSFET, the present invention can also applicable to a diode having high breakdown-voltage proof structure, a thyristor (SCR), IPD (intelligent power device), IPM (intelligent power module) and the like.

The field limiting ring or the field plate can be used in combination with each of the embodiments described in the above when a semiconductor having a reliable high breakdown-voltage proof characteristic is desired even though the device has larger profile. As a result of using these techniques, a semiconductor device having a planar type vertical element with high breakdown-voltage proof structure which satisfied with a reliable high breakdown-voltage proof characteristic without much increase of power consumption can be obtained.

In the semiconductor device of the present invention, the impurity region of second conductive type is formed in the very low density impurity layer of first conductive type, and impurity density of the very low density impurity layer of first conductive type is relatively lower than that of the impurity layer of first conductive type. The value of theoretical breakdown-voltage is in inversely proportional to the impurity density. So that, the value of theoretical breakdown-voltage of the very low density impurity layer of first conductive type is greater than that of the impurity layer of first conductive type. Surface breakdown-voltage can be increased for the amount of the increased voltage. Also, the impurity layer of first conductive type having relatively lower electric resistance than the very low density impurity layer of first conductive type is located underneath the very low density impurity layer of first conductive type formed adjacently to the surface in order to increase a value of the surface breakdown-voltage to a high level. Therefore, lower power consumption can be expected in comparison with when the impurity layer of first conductive type is not provided underneath the very low density impurity layer of first conductive type. As a result, a semiconductor device having a planar type vertical element with high breakdown-voltage proof structure which satisfied with a reliable high breakdown-voltage proof characteristic and occupies smaller device formation region without much increase of power consumption can be realized.

In the semiconductor device of the present invention, the impurity layer of first conductive type is composed of the high density impurity layer of first conductive type and the low density impurity layer of first conductive type formed on the high density impurity layer of first conductive type. Thus, it is possible to secure a sufficient high breakdown-voltage proof characteristic with maintaining lower power consumption by providing the low density impurity layer of first conductive type having lower electric resistance than the very low density impurity layer of first conductive type at underneath the very low density impurity layer of first conductive type formed adjacently to the surface in order to increase a value of the surface breakdown-voltage to a high level.

The semiconductor device of the present invention comprises the high density impurity layer of second conductive type formed underneath the high density impurity layer of first conductive type, the impurity region of first conductive type formed in the impurity region of second conductive type, the gate oxidation film which covers the surface of the impurity region of second conductive and the gate electrode formed on the gate oxidation film. Therefore, an IGBT realizing high surface breakdown-voltage with maintaining lower power consumption can be obtained. As a result of that, it is possible to provide a semiconductor device having an IGBT which satisfied with a reliable high breakdown-voltage proof characteristic and occupies smaller device formation region with lower power consumption.

In the semiconductor device of the present invention, the bottom surface of the impurity region of second conductive type reaches to the low density impurity layer of first conductive type. Therefore, lower power consumption is expected because electric resistance of the semiconductor substrate itself can be decreased. Thus, it is possible to provide a semiconductor device having a planar type vertical element with high breakdown-voltage proof structure which consumes lower power with maintaining the surface breakdown-voltage at a high level.

In the method for manufacturing a semiconductor device of the present invention, the high density impurity layer of first conductive type is formed by carrying out thermal diffusion of first conductive type impurities on the surface of the semiconductor substrate implanted the first conductive type impurities at a low density. And the very low density impurity layer of first conductive type is formed by a method of epitaxial growth on a surface of the semiconductor substrate where the high density impurity layer of first conductive type is not formed. In other words, the semiconductor substrate is formed by carrying out a total of one epitaxial growth process because formation of the high density impurity layer of first conductive type is implemented by thermal diffusion processes. So that, the manufacturing processes can be simplified in comparison with when the semiconductor substrate is formed by using epitaxial growth method only.

Also, the very low density impurity layer of first conductive type is formed on a surface of the high density impurity layer of first conductive type of the semiconductor substrate where the high density impurity layer of first conductive type is not formed, so that the semiconductor device does not receive much influences of crystal defects caused by the thermal history applied thereto.

Further, since the high density impurity layer of first conductive type is formed by carrying out thermal diffusion of first conductive type impurities on the surface of semiconductor substrate, a gentle boundary of impurity density between the semiconductor substrate and the high density impurity layer of first conductive type is observed. Therefore, the semiconductor device made under this manufacturing method can be operated under short width pulses, and it offers a wide range of proper operation because of comprising above described features.

In other words, it is possible to provide a semiconductor device having a planar type vertical element with high breakdown-voltage proof structure which satisfied with a reliable high breakdown-voltage proof characteristic and occupies smaller device formation region with lower power consumption.

In the method for manufacturing a semiconductor device of the present invention, the high density layer of second conductive type is formed by carrying out thermal diffusion of second conductive type impurities on a surface of the high density impurity layer of first conductive type. The high density impurity layer of second conductive type is formed on the other surface located adjacent to the semiconductor substrate. The impurity region of first conductive type is formed in the impurity region of second conductive type. The gate oxidation film which covers the surface of the impurity region of second conductive type is formed, the gate electrode is formed on the gate oxidation film. Therefore, an IGBT realizing high surface breakdown-voltage characteristic with maintaining lower power consumption can be manufactured under simple processes because of comprising the processes described in the above. As a result of that, it is possible to provide a manufacturing method for a semiconductor device having an IGBT which satisfied with a reliable high breakdown-voltage proof characteristic and occupies smaller device formation region with lower power consumption.
While the invention has been described in its preferred embodiments, it is to be understood that the words which have been used are words of description rather than limitation and that changes within the purview of the appended claims may be made without departing from the true scope and spirit of the invention in its broader aspects.

## Claims

1. A semiconductor device having a planar type vertical element with high breakdown-voltage proof structure comprising:
an impurity layer of first conductive type,
a very low impurity layer of first conductive type located on the impurity layer of first conductive type, the very low density impurity layer of first conductive type having lower impurity density than the impurity layer of first conductive type, and
an impurity region of second conductive type located in the very low density impurity layer of first conductive type.

2. A semiconductor device having a planar type vertical element with high breakdown-voltage proof structure in accordance with claim 1,
wherein the impurity layer of first conductive type comprises a high density impurity layer of first conductive type and a low density impurity layer of first conductive type located on the high density impurity layer of first conductive type.

3. A semiconductor device having a planar type vertical element with high breakdown-voltage proof structure in accordance with claim 2, further comprising:
a high density impurity layer of second conductive type located under the high density impurity layer of first conductive type,
an impurity region of first conductive type located in the impurity region of second conductive type,
a gate oxidation film covering the impurity region of second conductive type, and
a gate electrode located on the gate oxidation film, the gate electrode generating a first conductive type channel on a surface of the high density impurity layer of second conductive type when a voltage greater than a threshold voltage being applied thereto, so that the impurity region of first conductive type and the very low density impurity layer of first conductive type being connected electrically with each other.

4. A semiconductor device having a planar type vertical element with high breakdown-voltage proof structure in accordance with claim 1, wherein bottom surface of the impurity region of second conductive type reaches to the low density impurity layer of first conductive type.

5. A method for manufacturing a semiconductor device having a planar type vertical element with high breakdown-voltage proof structure comprising:
forming a high density impurity layer of first conductive type by carrying out thermal diffusion of first conductive type impurities on a surface of a semiconductor substrate being implanted the first conductive type impurities at a low density,
forming a low density impurity layer of first conductive type having lower impurity density than the semiconductor substrate by utilizing epitaxial growth method on a surface of the semiconductor substrate where the high density impurity layer of first conductive type is not formed, and
forming an impurity region of second conductive type in the very low density impurity layer of first conductive type.

6. A method for manufacturing a semiconductor device having a planar type vertical element with high breakdown-voltage proof structure in accordance with claim 5, the improvement comprising:
forming a high density impurity layer of second conductive type by carrying out thermal diffusion of second conductive type impurities on a surface of the high density impurity layer of first conductive type, the surface not being adjacent to the semiconductor substrate,
forming an impurity region of first conductive type in the impurity region of second conductive type,
forming a gate oxidation film covering a surface of the impurity region of second conductive type,
forming a gate electrode on the gate oxidation film, the gate electrode generating a first conductive type channel on a surface of the high density impurity layer of second conductive type when a voltage greater than a threshold voltage being applied thereto, so that the impurity region of first conductive type and the very low density impurity layer of first conductive type being connected electrically with each other.
